# EUROPEAN PATENT SPECIFICATION

(11) **EP 4 488 563 B1**
(45) Date of publication and mention of the grant of the patent: **06.05.2026**
(21) Application number: 22933712.6
(22) Date of filing: 21.03.2022
(51) Int. Cl.: F16M 11/22, F16M 11/20, F16M 11/04, A47B 13/00

(54) **DISPLAY STAND AND DISPLAY DEVICE**
ANZEIGESTÄNDER UND ANZEIGEVORRICHTUNG
SUPPORT D'AFFICHEUR ET DISPOSITIF D'AFFICHAGE

(43) Date of publication of application: 08.01.2025
(73) Proprietor: LG Electronics Inc., Yeongdeungpo-gu Seoul 07336 (KR)
(72) Inventor: HAN, Dongyoup, Seoul 06772 (KR); LEE, Choonhwa, Seoul 06772 (KR); LEE, Jaejun, Seoul 06772 (KR); KIM, Hansoo, Seoul 06772 (KR); MOON, Byeonggi, Seoul 06772 (KR); SEO, Minwoong, Seoul 06772 (KR)
(74) Representative: Schornack, Oliver
(86) International application number: PCT/KR2022/003916
(87) International publication number: WO 2023/182539

(56) References cited:
- AU-A1- 2019 424 684
- CN-U- 207 880 359
- DE-U1- 202007 013 098
- JP-A- 2003 061 010
- JP-A- 2006 227 405
- JP-A- 2007 010 989
- JP-A- 2009 150 456
- KR-A- 20020 092 710
- KR-Y1- 200 319 602
- KR-Y1- 200 349 572
- US-A1- 2021 247 015
- US-B2- 10 271 917

## Description

### [Technical Field]

The disclosure relates to a display stand that may be applied to display devices of various sizes and mounted on a floor, and a display device including the same.

### [Background Art]

With growth of information society, demand for various display devices has increased. In order to satisfy such demand, in recent years, a liquid crystal display (LCD), a field emission display (FED), a plasma display panel (PDP), and an electroluminescent device have been developed as display devices.

A liquid crystal panel of the liquid crystal display includes a liquid crystal layer and a TFT substrate and a color filter substrate opposite each other in the state in which the liquid crystal layer is interposed therebetween, wherein a picture is displayed using light provided from a backlight unit.

An active matrix type organic light-emitting display has come onto the market as an example of the electroluminescent device. Since the organic light-emitting display is self-emissive, the organic light-emitting display has no backlight, compared to the liquid crystal display, and has merits in terms of response time and viewing angle, and therefore the organic light-emitting display has attracted attention as a next-generation display.

Display devices may be mounted in various manners. Placing a display device on a shelf or table or hanging it on a wall is common. However, a floor-standing type has become popular because it provides a picture frame-like appearance.

To mount a display device on a wall, a separate bracket may be fixedly fastened to a VESA standard-based fastening structure located on the rear surface of a display body.

However, for a floor-mounted stand, there is no standardized fastening structure, and thus a stand structure with legs inserted into the bottom of the display device should be provided, and the stand structure at the bottom of the display device causes problems such as an increased volume or difficulty in mounting it closely to a wall.

Furthermore, US 10,271,917 B2 relates to a surgical tray system for use in an operating room during surgery to hold instruments. The tray system includes a multi-level rack with adjustable angle shelves, and a vertical support including first and second leg elements.

### [Disclosure]

### [Technical Problem]

The present invention is directed to the object to provide a display stand that may be applied to display devices of various sizes and mounted on a floor, and a display device including the same.

### [Technical Solution]

This object is solved by the present invention as claimed in the independent claims. Preferred embodiments are derivable from the dependent claims.

In accordance with an exemplary aspect of the present disclosure, a display stand includes: a stand body extending in a horizontal direction; a plurality of stand legs fastened to a leg bracket of the stand body; a back bracket coupled to a rear surface of the display body; and an L-shaped neck portion including a first fixing portion coupled to the back bracket and a second fixing portion coupled to the stand body. The leg bracket includes second spirals engaged with first spirals located in upper portions of the plurality of stand legs and guide portions extending downward from the second spirals.

The plurality of stand legs include: a front leg extending obliquely from the stand body in a front direction; and a rear leg extending obliquely from the stand body in a back direction. The front leg is longer than the rear leg.

The leg bracket includes a first leg fastening portion to which the front leg is coupled and a second leg fastening portion to which the rear leg is coupled, and the first leg fastening portion is tilted at a greater angle with respect to a vertical direction than the second leg fastening portion.

The rear leg may include a cable holder for fixing a cable.

The back bracket may include a first fastening hole fastened to the first fixing portion of the neck portion, and second fastening holes coupled to the display body, and the second fastening holes may be arranged at an interval based on a Video Electronics Standards Association (VESA) standard.

The back bracket may include a plurality of first fastening holes to change a fastening position of the back bracket on the neck portion.

In the back bracket, a first region where the first fastening hole is located may be spaced apart from the display body by a predetermined distance, and a second region where the second fastening holes are located may be in close contact with the rear surface of the display body. The second fixing portion of the neck portion may be located in a separation space between the first region of the back bracket and the display body.

The back bracket may include a plurality of heat dissipation holes.

The display stand may further include a fixing clip inserted into the plurality of heat dissipation holes.

The display stand may further include a storage portion on the stand body.

### [Advantageous Effects]

As a display stand of the disclosure may minimize the size of a display body, it may be easily converted into a wall-mounted type or a floor-mounted type.

Further, when a floor surface is not flat, the lengths of legs may be adjusted to make it level.

Further, a leg bracket may include guide portions to fasten the legs to accurate positions, and even if fastening portions are loosened, the guide portions may support the display device.

Further, a set-top box or a Wi-Fi repeater may be mounted on the rear surface of the display device, which obviates the need for separate storage furniture.

Effects obtainable from the present disclosure may be non-limited by the above-mentioned effects. And, other unmentioned effects may be clearly understood from the following description by those having ordinary skill in the technical field to which the present disclosure pertains.

### [Description of Drawings]

FIG. 1 is a block diagram illustrating components of a display device according to the disclosure.
FIG. 2 is a perspective view illustrating an example of the display device according to the disclosure.
FIG. 3 is a front perspective view and side view illustrating the example of the display device according to the disclosure.
FIG. 4 is a rear perspective view illustrating the example of the display device according to the disclosure.
FIG. 5 is an exploded perspective view illustrating an example of a display stand according to the disclosure.
FIG. 6 is a cross-sectional view illustrating fastening between a leg bracket and legs of the display stand according to the disclosure.
FIG. 7 is a diagram illustrating a method of adjusting the length of a leg of the display stand according to the disclosure.
FIG. 8 is a cross-sectional view taken along line B-B of FIG. 4.
FIG. 9 is an exploded perspective view illustrating another example of the display stand according to the disclosure.
FIG. 10 is a rear view illustrating the display stand according to the disclosure.
FIG. 11 is a diagram illustrating a conversion aspect of the display stand according to the disclosure.

### [Best Mode]

Description will now be given in detail according to exemplary embodiments disclosed herein, with reference to the accompanying drawings. For the sake of brief description with reference to the drawings, the same or equivalent components may be provided with the same reference numbers, and description thereof will not be repeated. In general, a suffix such as "module" and "unit" may be used to refer to elements or components. Use of such a suffix herein is merely intended to facilitate description of the specification, and the suffix itself is not intended to give any special meaning or function. In the present disclosure, that which is well-known to one of ordinary skill in the relevant art has generally been omitted for the sake of brevity. The accompanying drawings are used to help easily understand various technical features and it should be understood that the embodiments presented herein are not limited by the accompanying drawings.

It will be understood that although the terms first, second, etc. may be used herein to describe various elements, these elements should not be limited by these terms. These terms are generally only used to distinguish one element from another.

It will be understood that when an element is referred to as being "connected with" another element, the element may be directly connected with the other element or intervening elements may also be present. In contrast, when an element is referred to as being "directly connected with" another element, there are no intervening elements present.

A singular representation may include a plural representation unless it represents a definitely different meaning from the context.

Terms such as "include" or "has" are used herein and should be understood that they are intended to indicate an existence of several components, functions or steps, disclosed in the specification, and it is also understood that greater or fewer components, functions, or steps may likewise be utilized.

Meanwhile, an image display device described in this specification is, for example, an intelligent image display device having a computer supporting function in addition to a broadcast reception function, wherein an Internet function may be added while the broadcast reception function is devotedly performed, whereby an interface that is more conveniently used, such as a handwriting type input device, a touchscreen, or a space remote control, may be provided. In addition, the image display device may be connected to the Internet or a computer through support of a wired or wireless Internet function, whereby various functions, such as e-mail, web browsing, banking, or gaming, may be executed. For such various functions, a standardized general-purpose OS may be used.

In the image display device described in the present disclosure, therefore, various applications may be freely added or deleted, for example, on a general-purpose OS kernel, whereby various user friendly functions may be executed. More specifically, the image display device may be a network TV, an Hbb TV, or a smart TV, and is applicable to a smartphone depending on circumstances.

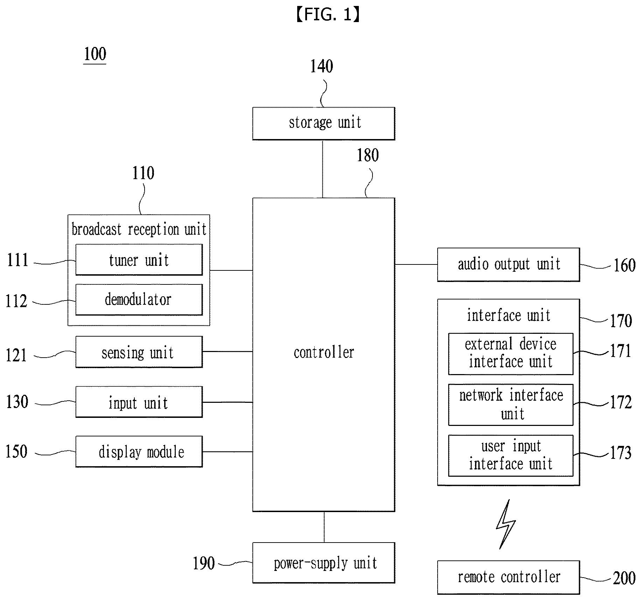

FIG. 1 is a block diagram illustrating components of a display device 100. The display device 100 may include a broadcast reception unit 110, an external device interface unit 171, a network interface unit 172, a storage unit 140, a user input interface unit 173, an input unit 130, a controller 180, a display module 150, an audio output unit 160, and/or a power supply unit 190.

The broadcast reception unit 110 may include a tuner unit 111 and a demodulation unit 112.

Unlike the figure, on the other hand, the display device 100 may include only the external device interface unit 171 and the network interface unit 172, among the broadcast reception unit 110, the external device interface unit 171, and the network interface unit 172. That is, the display device 100 may not include the broadcast reception unit 110.

The tuner unit 111 may select a broadcast signal corresponding to a channel selected by a user or any one of all pre-stored channels, among broadcast signals received through an antenna (not shown) or a cable (not shown). The tuner unit 111 may convert the selected broadcast signal into an intermediate frequency signal or a baseband video or audio signal.

For example, when the selected broadcast signal is a digital broadcast signal, the tuner unit 111 may convert the broadcast signal into a digital IF (DIF) signal, and when the selected broadcast signal is an analog broadcast signal, the tuner unit 111 may convert the broadcast signal into an analog baseband video or audio (CVBS/SIF) signal. That is, the tuner unit 111 may process the digital broadcast signal or the analog broadcast signal. The analog baseband video or audio (CVBS/SIF) signal output from the tuner unit 111 may be directly input to the controller 180.

Meanwhile, the tuner unit 111 may sequentially select broadcast signals of all broadcast channels stored through a channel memory function, among received broadcast signals, and may convert each of the selected broadcast signals into an intermediate frequency signal or a baseband video or audio signal.

Meanwhile, the tuner unit 111 may include a plurality of tuners in order to receive broadcast signals of a plurality of channels. Alternatively, a single tuner may simultaneously receive broadcast signals of a plurality of channels.

The demodulation unit 112 may receive the digital IF (DIF) signal converted by the tuner unit 111, and may perform demodulation. After performing demodulation and channel decryption, the demodulation unit 112 may output a stream signal (TS). At this time, the stream signal may be a multiplexed image, audio, or data signal.

The stream signal output from the demodulation unit 112 may be input to the controller 180. After performing demultiplexing and image/audio signal processing, the controller 180 may output an image through the display module 150, and may output audio through the audio output unit 160.

The sensing unit 120 is a device configured to sense change inside or outside the display device 100. For example, the sensing unit 120 may include at least one of a proximity sensor, an illumination sensor, a touch sensor, an infrared (IR) sensor, an ultrasonic sensor, an optical sensor (e.g. a camera), an audio sensor (e.g. a microphone), a battery gauge, and an environmental sensor (e.g. a hygrometer or a thermometer).

The controller 180 may check the state of the display device 100 based on information collected by the sensing unit, and when a problem occurs, may inform a user of the same or may solve the problem, whereby the controller may perform control such that the display device is maintained in the best state.

In addition, the controller may differently control the content, quality, and size of an image provided to the display module 150 based on a viewer or ambient light sensed by the sensing unit in order to provide the optimum viewing environment. With progress of a smart TV, a large number of functions have been loaded in the display device, and the sensing unit 20 has also been increased in number.

The input unit 130 may be provided at one side of a main body of the display device 100. For example, the input unit 130 may include a touchpad or a physical button. The input unit 130 may receive various user commands related to the operation of the display device 100, and may transmit control signals corresponding to the received commands to the controller 180.

With a decrease in size of a bezel of the display device 100, many display devices 100 have been configured such that the number of physical button type input units 130 exposed to the outside is minimized in recent years. Instead, a minimum number of physical buttons is located at the rear surface or the side surface of the display device, and the display device may receive user input through the touchpad or the user input interface unit 173, a description of which will follow, using a remote controller 200.

The storage unit 140 may store programs for signal processing and control in the controller 180, and may store a processed image, audio, or data signal. For example, the storage unit 140 may store application programs designed to execute various tasks that may be processed by the controller 180, and may selectively provide some of the stored application programs in response to request of the controller 180.

Programs stored in the storage unit 140 are not particularly restricted as long as the programs may be executed by the controller 180. The storage unit 140 may temporarily store an image, audio, or data signal received from an external device through the external device interface unit 171. The storage unit 140 may store information about a predetermined broadcast channel through a channel memory function, such as a channel map.

FIG. 1 shows an embodiment in which the storage unit 140 and the controller 180 are separately provided; however, the present disclosure is not limited thereto. The storage unit 140 may be included in the controller 180.

The storage unit 140 may include at least one of a volatile memory (e.g. DRAM, SRAM, or SDRAM), a nonvolatile memory (e.g. flash memory), a hard disk drive (HDD), and a solid-state drive (SSD).

The display module 150 may convert an image signal, a data signal, an OSD signal, and a control signal processed by the controller 180 or an image signal, a data signal, and a control signal received from the interface unit 171 to generate a driving signal. The display module 150 may include a display panel 181 having a plurality of pixels.

Each of the plurality of pixels in the display panel may include RGB subpixels. Alternatively, each of the plurality of pixels in the display panel may include RGBW subpixels. The display module 150 may convert an image signal, a data signal, an OSD signal, and a control signal processed by the controller 180 to generate a driving signal for the plurality of pixels.

A plasma display panel (PDP), a liquid crystal display (LCD), an organic light-emitting diode (OLED), or a flexible display may be used as the display module 150, and a 3D display may also be used. The 3D display 130 may be classified as a non-glasses type display or a glasses type display.

The display device includes a display module, which occupies a major portion of the front surface thereof, and a case configured to cover the rear surface and the side surface of the display module, the case being configured to package the display module.

In recent years, the display device 100 has used a flexible display module 150, such as light-emitting diodes (LED) or organic light-emitting diodes (OLED), in order to implement a curved screen.

Light is supplied to an LCD, which was mainly used conventionally, through a backlight unit, since the LCD is not self-emissive. The backlight unit is a device that supplies light emitted from a light source to a liquid crystal uniformly located in front thereof. As the backlight unit has been gradually thinned, a thin LCD has been implemented. However, it is difficult to implement the backlight unit using a flexible material. If the backlight unit is curved, it is difficult to supply uniform light to the liquid crystal, whereby the brightness of a screen is changed.

In contrast, the LED or the OLED may be implemented so as to be curved, since an element constituting each pixel is self-emissive, and therefore no backlight unit is used. In addition, since each element is self-emissive, the brightness of the element is not affected even though the positional relationship between adjacent elements is changed, and therefore it is possible to implement a curved display module 150 using the LED or the OLED.

An organic light-emitting diode (OLED) panel appeared in earnest in mid 2010 and has rapidly replaced the LCD in the small- or medium-sized display market. The OLED is a display manufactured using a self-emissive phenomenon of an organic compound in which the organic compound emits light when current flows in the organic compound. The response time of the OLED is shorter than the response time of the LCD, and therefore afterimages hardly appear when video is implemented.

The OLED is an emissive display product that uses three fluorescent organic compounds having a self-emissive function, such as red, green, and blue fluorescent organic compounds and that uses a phenomenon in which electrons injected at a negative electrode and a positive electrode and particles having positive charges are combined in the organic compounds to emit light, and therefore a backlight unit, which deteriorates color, is not needed.

A light-emitting diode (LED) panel is based on technology of using one LED element as one pixel. Since it is possible to reduce the size of the LED element, compared to a conventional device, it is possible to implement a curved display module 150. The conventional device, which is called an LED TV, uses the LED as a light source of a backlight unit that supplies light to the LCD, and therefore the LED does not constitute a screen.

The display module includes a display panel and a coupling magnet, a first power supply unit, and a first signal module located at a rear surface of the display panel. The display panel may include a plurality of pixels R, G, and B. The plurality of pixels R, G, and B may be formed at intersections between a plurality of data lines and a plurality of gate lines. The plurality of pixels R, G, and B may be disposed or arranged in a matrix form.

For example, the plurality of pixels R, G, and B may include a red subpixel 'R', a green subpixel 'G', and a blue subpixel 'B'. The plurality of pixels R, G, and B may include a white subpixel 'W'.

The side of the display module 150 on which a picture is displayed may be referred to as a front side or a front surface. When the display module 150 displays the picture, the side of the display module 150 from which the picture cannot be viewed may be referred to as a rear side or a rear surface.

Meanwhile, the display module 150 may be constituted by a touchscreen, whereby an input device may also be used in addition to an output device.

The audio output unit 160 receives an audio signal processed by the controller 180 and outputs the same as audio.

The interface unit 170 serves as a path to various kinds of external devices connected to the display device 100. The interface unit may include a wireless system using an antenna as well as a wired system configured to transmit and receive data through a cable.

The interface unit 170 may include at least one of a wired/wireless headset port, an external charger port, a wired/wireless data port, a memory card port, a port for connection with a device having an identification module, an audio input/output (I/O) port, a video input/output (I/O) port, and an earphone port.

The broadcast reception unit 110 may be included as an example of the wireless system, and a mobile communication signal, a short-range communication signal, and a wireless Internet signal as well as a broadcast signal may be included.

The external device interface unit 171 may transmit or receive data to or from a connected external device. To this end, the external device interface unit 171 may include an A/V input and output unit (not shown).

The external device interface unit 171 may be connected to an external device, such as a digital versatile disc (DVD) player, a Blu-ray player, a game console, a camera, a camcorder, a computer (laptop computer), or a set-top box, in wired/wireless manner, and may perform input/output operation for the external device.

In addition, the external device interface unit 171 may establish a communication network with various remote controllers 200 in order to receive a control signal related to the operation of the display device 100 from each remote controller 200 or to transmit data related to the operation of the display device 100 to each remote controller 200.

The external device interface unit 171 may include a wireless communication unit (not shown) for short-range wireless communication with another electronic device. The external device interface unit 171 may exchange data with a mobile terminal adjacent thereto through the wireless communication unit (not shown). Particularly, in a mirroring mode, the external device interface unit 171 may receive device information, information of an application that is executed, and an image of the application from the mobile terminal.

The network interface unit 172 may provide an interface for connection of the display device 100 with a wired/wireless network including the Internet. For example, the network interface unit 172 may receive content or data provided by an Internet or content provider or a network operator through the network. Meanwhile, the network interface unit 172 may include a communication module (not shown) for connection with the wired/wireless network.

The external device interface unit 171 and/or the network interface unit 172 may include a communication module for short-range communication, such as Wi-Fi, Bluetooth, Bluetooth Low Energy (BLE), ZigBee, or Near Field Communication (NFC), or a communication module for cellular communication, such as Long-Term Evolution (LTE), LTE Advance (LTE-A), Code Division Multiple Access (CDMA), Wideband CDMA (WCDMA), Universal Mobile Telecommunications System (UMTS), or Wireless Broadband (WiBro).

The user input interface unit 173 may transmit a user input signal to the controller 180, or may transmit a signal from the controller 180 to a user. For example, the user input interface unit may transmit/receive a user input signal, such as power on/off, channel selection, or screen setting, to/from the remote controller 200, may transmit a user input signal, such as a power key, a channel key, a volume key, or a setting value, input from a local key (not shown) to the controller 180, may transmit a user input signal input from a sensor unit (not shown) configured to sense user gesture to the controller 180, or may transmit a signal from the controller 180 to the sensor unit.

The controller 180 may include at least one processor, and may control the overall operation of the display device 100 using the processor included therein. Here, the processor may be a general processor, such as a central processing unit (CPU). Of course, the processor may be a dedicated device, such as an ASIC, or another hardware-based processor.

The controller 180 may demultiplex a stream input through the tuner unit 111, the demodulation unit 112, the external device interface unit 171, or the network interface unit 172, or may process demultiplexed signals to generate and output a signal for image or audio output.

An image signal processed by the controller 180 may be input to the display module 150, which may display an image corresponding to the image signal. In addition, the image signal processed by the controller 180 may be input to an external output device through the external device interface unit 171.

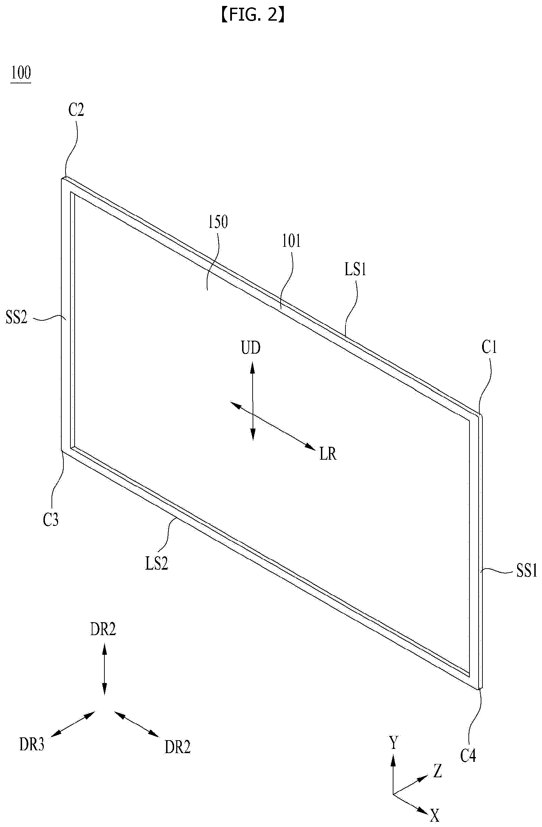

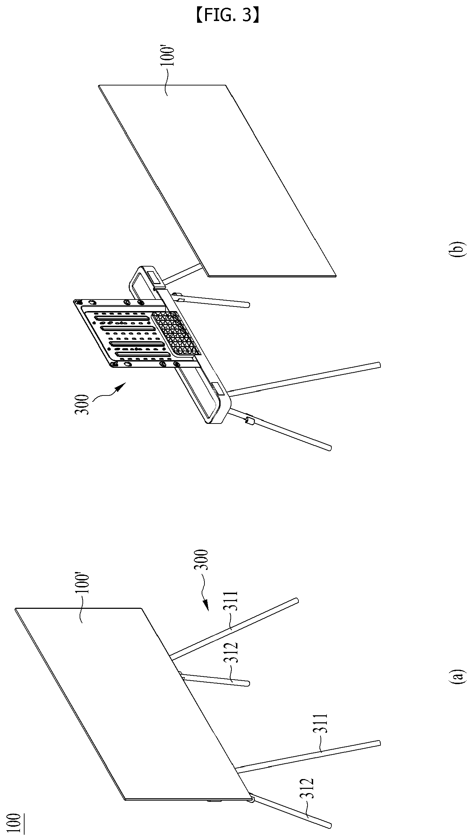

An audio signal processed by the controller 180 may be output through the audio output unit 160. In addition, the audio signal processed by the controller 180 may be input to an external output device through the external device interface unit 171. Although not shown in FIG. 2, the controller 180 may include a demultiplexing unit and an image processing unit, which will be described below with reference to FIG. 3.

Further, the controller 180 may control the overall operation of the display device 100. For example, the controller 180 may control the tuner unit 111 such that a broadcast corresponding to a channel selected by a user or a pre-stored channel is tuned.

In addition, the controller 180 may control the display device 100 according to a user command input through the user input interface unit 173 or an internal program. Meanwhile, the controller 180 may control the display module 150 to display an image. At this time, the image displayed on the display module 150 may be a still image or video, or may be a 2D image or a 3D image.

Meanwhile, the controller 180 may perform control such that a predetermined 2D object is displayed in an image displayed on the display module 150. For example, the object may be at least one of a connected web screen (newspaper or magazine), an electronic program guide (EPG), various menus, a widget, an icon, a still image, video, and text.

Meanwhile, the controller 180 may modulate and/or demodulate a signal using an amplitude shift keying (ASK) method. Here, the amplitude shift keying (ASK) method may be a method of changing the amplitude of a carrier depending on a data value to modulate a signal or restoring an analog signal to a digital data value depending on the amplitude of a carrier.

For example, the controller 180 may modulate an image signal using the amplitude shift keying (ASK) method, and may transmit the modulated image signal through a wireless communication module.

For example, the controller 180 may demodulate and process an image signal received through the wireless communication module using the amplitude shift keying (ASK) method.

As a result, the display device 100 may easily transmit and receive a signal to and from another image display device disposed adjacent thereto without using a unique identifier, such as a media access control (MAC) address, or a complicated communication protocol, such as TCP/IP.

Meanwhile, the display device 100 may further include a photographing unit (not shown). The photographing unit may photograph a user. The photographing unit may be implemented by one camera; however, the present disclosure is not limited thereto. The photographing unit may be implemented by a plurality of cameras. Meanwhile, the photographing unit may be embedded in the display device 100 above the display module 150, or may be separately disposed. Image information photographed by the photographing unit may be input to the controller 180.

The controller 180 may recognize the location of a user based on an image captured by the photographing unit. For example, the controller 180 may recognize the distance between the user and the display device 100 (z-axis coordinate). Further, the controller 180 may recognize an x-axis coordinate and a y-axis coordinate in the display module 150 corresponding to the location of the user.

The controller 180 may sense user gesture based on the image captured by the photographing unit, a signal sensed by the sensor unit, or a combination thereof.

The power supply unit 190 may supply power to the components of the display device 100. In particular, the power supply unit may supply power to the controller 180, which may be implemented in the form of a system on chip (SOC), the display module 150 for image display, and the audio output unit 160 for audio output.

Specifically, the power supply unit 190 may include an AC/DC converter (not shown) configured to convert AC power into DC power and a DC/DC converter (not shown) configured to convert the level of the DC power.

Meanwhile, the power supply unit 190 serves to distribute power supplied from the outside to the respective components of the display device. The power supply unit 190 may be directly connected to an external power supply in order to supply AC power, or may include a battery so as to be used by charging.

In the former case, a cable is used, and the power supply unit is difficult to move or the movement range of the power supply unit is limited. In the latter case, the power supply unit is free to move, but the weight of the power supply unit is increased in proportion to the weight of the battery, the volume of the power supply unit is increased, and, for charging, the power supply unit must be directly connected to a power cable or must be coupled to a charging holder (not shown) that supplies power for a predetermined time.

The charging holder may be connected to the display device through a terminal exposed to the outside, or the battery mounted in the power supply unit may be charged in a wireless manner when the power supply unit approaches the charging holder.

The remote controller 200 may transmit user input to the user input interface unit 173. To this end, the remote controller 200 may use Bluetooth communication, radio frequency (RF) communication, infrared radiation communication, ultra-wideband (UWB) communication, or ZigBee communication. In addition, the remote controller 200 may receive an image, audio, or data signal output from the user input interface unit 173 so as to be displayed thereon or audibly output therefrom.

Meanwhile, the display device 100 may be a stationary or movable digital broadcast receiver capable of receiving a digital broadcast.

Meanwhile, the block diagram of the display device 100 shown in FIG. 1 is for an embodiment of the present disclosure, and elements of the block diagram may be integrated, added, or omitted depending on specifications of an actually implemented display device 100.

That is, two or more elements may be integrated into one element, or one element may be divided into two or more elements, as needed. In addition, the function performed by each block is for describing the embodiment of the present disclosure, and the specific operations and components thereof do not limit the scope of rights of the present disclosure.

FIG. 2 is a front perspective view illustrating an example of the display device.

Referring to FIG. 2, the display device 100 may have a rectangular shape including a first long side LS1, a second long side LS2 opposite the first long side LS1, a first short side SS1 adjacent to the first long side LS1 and the second long side LS2, and a second short side SS2 opposite the first short side SS1.

Here, the area of the first short side SS1 may be referred to as a first side area, the area of the second short side SS2 may be referred to as a second side area opposite the first side area, the area of the first long side LS1 may be referred to as a third side area adjacent to the first side area and the second side area and located between the first side area and the second side area, and the area of the second long side LS2 may be referred to as a fourth side area adjacent to the first side area and the second side area, located between the first side area and the second side area, and opposite the third side area.

In addition, the lengths of the first and second long sides LS1 and LS2 are shown and described as being greater than the lengths of the first and second short sides SS1 and SS2, for convenience of description; however, the lengths of the first and second long sides LS1 and LS2 may be approximately equal to the lengths of the first and second short sides SS1 and SS2.

Also, in the following description, a first direction DR1 may be a direction parallel to the long sides LS1 and LS2 of the display device 100, and a second direction DR2 may be a direction parallel to the short sides SS1 and SS2 of the display device 100. A third direction DR3 may be a direction perpendicular to the first direction DR1 and/or the second direction DR2.

From a different point of view, the side of the display device 100 on which a picture is displayed may be referred to as a front side or a front surface. When the display device 100 displays the picture, the side of the display device 100 from which the picture cannot be viewed may be referred to as a rear side or a rear surface. When viewing the display device 100 from the front side or the front surface, the side of the first long side LS1 may be referred to as an upper side or an upper surface. In the same manner, the side of the second long side LS2 may be referred to as a lower side or a lower surface. In the same manner, the side of the first short side SS1 may be referred to as a right side or a right surface, and the side of the second short side SS2 may be referred to as a left side or a left surface.

In addition, the first long side LS1, the second long side LS2, the first short side SS1, and the second short side SS2 may be referred to edges 351 of the display device 100. In addition, points at which the first long side LS1, the second long side LS2, the first short side SS1, and the second short side SS2 are joined to each other may be referred to as corners. For example, a point at which the first long side LS1 and the first short side SS1 are joined to each other may be a first corner C1, a point at which the first long side LS1 and the second short side SS2 are joined to each other may be a second corner C2, a point at which the second short side SS2 and the second long side LS2 are joined to each other may be a third corner C3, and a point at which the second long side LS2 and the first short side SS1 are joined to each other may be a fourth corner C4.

Here, a direction from the first short side SS1 to the second short side SS2 or a direction from the second short side SS2 to the first short side SS1 may be referred to as a left-right direction LR. A direction from the first long side LS1 to the second long side LS2 or a direction from the second long side LS2 to the first long side LS1 may be referred to as an up-down direction UD.

FIG. 3 is a front perspective view illustrating an example of the display device 100 of the disclosure. (a) illustrates a state in which the display device is coupled to a display stand 300, and (b) illustrates a state in which the display device is separated from the display stand 300.

A display body 100' of the disclosure may include the display module 150, a cover bottom covering the rear surface of the display module 150, and a back cover covering a component mounted on the rear surface of the cover bottom.

As the thickness of the display module 150 has recently decreased and the components mounted on the rear surface thereof have become simpler, the display body 100' may become thinner. Since the display body 100' is thin, it may be hung tightly like a picture frame when mounted on a wall.

However, when the display device 100 is mounted on the floor, a separate stand should be fastened to the display device 100. Particularly, a floor-mounted stand may be provided with four stand legs 310 for balance and placed on the floor like a picture frame displayed in a gallery.

To position the four stand legs 310 at the bottom of the display body 100', the bottom of the body needs a leg coupler to be coupled to the stand legs 310. However, since the display body 100' is thin, the leg coupler is configured to be thicker than the display body 100' in order to place a pair of stand legs which extend while spreading in a front-back direction,.

When the leg coupler protrudes forward, it is difficult to provide a neat appearance, and when it protrudes backward, the rear surface of the body 100' should be spaced apart from a wall when the display device 100 is placed on the wall.

Moreover, since the structure of the stand is not universalized, the display stand 300 should be manufactured to have a separate design for each model.

Therefore, the disclosure provides the display stand 300 which may be applied to display devices 100 of various sizes and easily fastened and detached by using a standardized Video Electronics Standards Association (VESA) structure.

As illustrated in FIG. 3(b), the display stand 300 and the display body 100' may be separated from each other, and the display stand 300 may be coupled to the rear surface of the display body 100' depending on a mounting aspect, when needed.

As illustrated in FIG. 3(a), only the stand legs 310 extending downward from the display body 100' are visible from the front, which may minimize interference with image viewing.

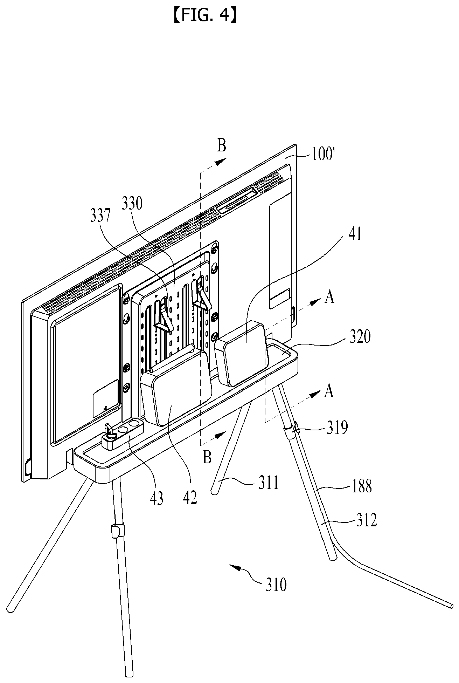

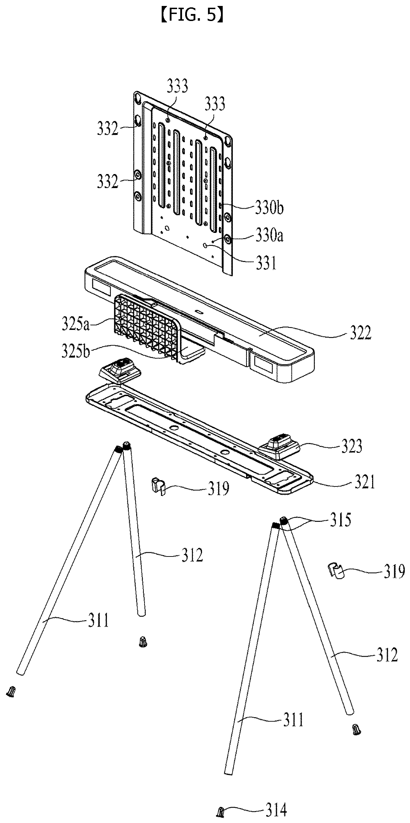

The configuration of the display stand 300 will be described below in more detail. FIG. 4 is a rear perspective view illustrating an example of the display device 100 according to the disclosure, and FIG. 5 is an exploded perspective view illustrating the example of the display stand 300 according to the disclosure.

The display stand 300 of the disclosure may be coupled to the rear surface of the display body 100' and support the display body 100' such that the display body 100' is located at a predetermined height from a floor surface. The display stand 300 includes a stand body 320, a plurality of stand legs 310 located at the bottom of the stand body 320, a back bracket 330 coupled to the rear surface of the display body 100', and a neck portion 325 connecting the back bracket 330 and the stand body 320 to each other.

The stand body 320 extends in a horizontal direction so that the plurality of stand legs 310 may be balanced and support the display body 100'. The stand body 320 may be configured to be located not at the bottom of the display device 100 but in the back direction so that the stand body 320 is not exposed in the front direction.

The stand body 320 has a rectangular shape and may include a lower body 321 and an upper body 322 as illustrated in FIG. 5. The lower body 321 may be formed by pressing a metal for rigidity, and the rigidity may be secured by forming unevenness.

The neck portion 325 fixed to the display body 100' and a leg bracket 323 to which the stand legs 310 are fixed are coupled to the lower body 321, and the lower body 321 actually functions as the stand body 320.

The upper body 322 may form an exterior by covering the neck portion 325 or the leg bracket 323 coupled to the lower body, and provide a flat storage space on its top. A set-top box 41, a wireless router 42, and an outlet 43 may be located on the top surface of the upper body 322.

The plurality of stand legs 310 coupled to the stand body 320 may include a pair of stand legs 310 located on each of left and right sides in the horizontal direction, and extending in the front-back direction for forward and backward balance of the display device 100.

Since the display body 100' is coupled to the front surface of the stand body 320 of the disclosure, the stand legs 310 coupled to the bottom of the stand body 320 may be configured to support a forward tilting force.

The four stand legs 310 may be coupled to the stand body 320 at predetermined angles, for stable support. To fasten each stand leg 310 to the stand body 320 at an accurate angle, the stand body 320 includes the leg bracket 323 into which top ends of the stand legs 310 are fixedly inserted.

The leg bracket 323 may be formed integrally with the stand body 320 by processing the stand body 320, and may be fastened to the stand body 320 using separate pieces, for rigidity and ease of manufacturing, as illustrated in FIG. 5.

One leg bracket 323 may be provided on each of the left and right sides, and a first leg fastening portion 323a and a second leg fastening portion 323b may be formed in the leg bracket 323 so that one front leg 311 and one rear leg 312 may be fastened to the leg bracket 323.

A friction member 314 may be provided on the bottom of each leg 310 to prevent slipping, and a first spiral 315 coupled to a leg fastening portion 323 may be formed in an upper portion of the leg 310.

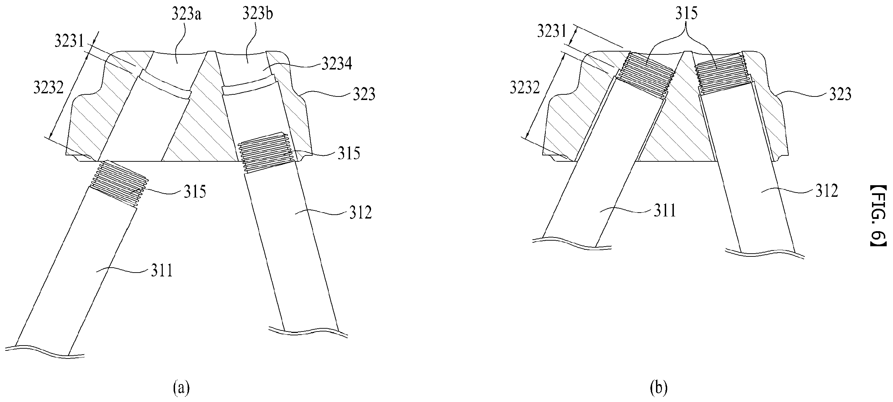

FIG. 6 is a cross-sectional view illustrating fastening between the stand legs 310 and the leg brackets 323 in the display stand 300 of the disclosure, taken along line A-A of FIG. 4. FIG. 6(a) illustrates a state before the legs 310 are fastened to the leg brackets 323, and FIG. 6(b) illustrates a state in which the legs 310 are fastened to the leg brackets 323.

A leg bracket 323 includes second spirals 3231 formed to be fastened to the first spirals 315 located at the upper portions of stand legs 310, and further include guide portions 3232 at the bottoms of the second spirals 3231 to guide angles at which the first spirals 315 and the second spirals 3231 are fastened.

Even if the stand legs 310 are released from the second spirals 3231, the guide portions 3232 may hold the stand legs, thereby preventing the legs from breaking or coming off. In addition, the lengths of the stand legs 310 may be adjusted by adjusting the degree of fastening between the second spirals 3231 and the first spirals 315.

Since it is not aesthetically pleasing for a power cable 188 connected to the display body 100' or a cable 188 for connection to a wire of the outlet accommodated on the stand body 320 to extend below the display body 100', it may extend downward along a rear leg 312, as illustrated in FIG. 4. To allow the cable 188 to extend along the rear leg 312, the rear leg 312 may be provided with a cable holder 319 that secures the cable.

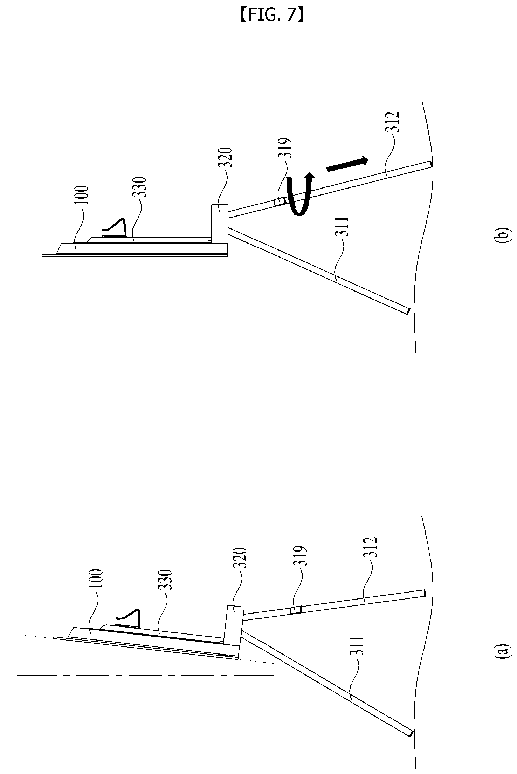

FIG. 7 is a diagram illustrating a method of adjusting the length of a stand leg 310 in the display stand 300 of the disclosure. As illustrated in (a), the display body 100' may be tilted in a situation where there is a slope or a floor surface is uneven. The length of a stand leg 310 in a tilted direction may be increased by loosening the leg from the second spiral 3231, and the display body 100' may be disposed in a vertical direction, as illustrated in (b).

Further, as illustrated in FIG. 7, the length of a front leg 311 extending in the front direction to support the display body 100' located on the front surface of the stand body 320 is greater than that of a rear leg 312 tilted in the back direction.

To balance the long front leg 311 and the short rear leg 312, the front leg 311 is tilted more forward with respect to the vertical direction. As illustrated in FIG. 6, the first leg fastening portion 323a is formed to be tilted at a greater angle with respect to the vertical direction than the second leg fastening portion 323b in the leg bracket 323, so that the front leg 311 and the rear leg 313 may be coupled to the stand body 320 at predetermined angles.

The neck portion 325 may connect the back bracket 330 and the stand body 320 to each other and transfer the weight of the display body 100' to the stand body 320. In the neck portion 325, a first fixing portion 325a coupled to the back bracket 330 and a second fixing portion 325b coupled to the stand body 320 may be arranged in an L shape.

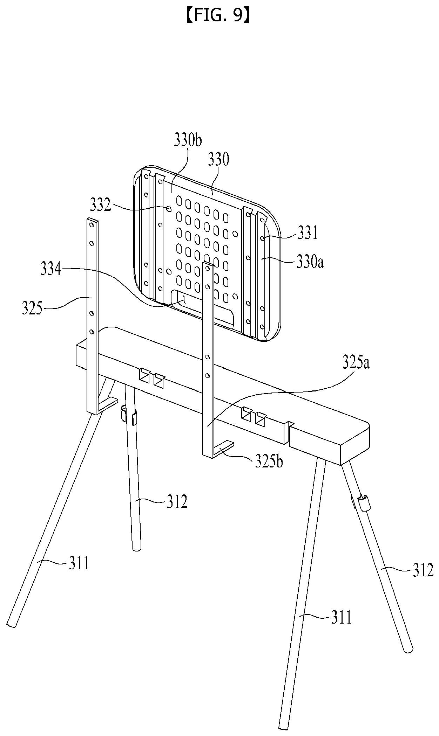

The neck portion 325 may have a shape extending long in the horizontal direction, as illustrated in FIG. 5, and may be implemented thin by use of a rigid bar, as in the embodiment illustrated in FIG. 9. The embodiment of FIG. 5 may be implemented using an injection, whereas the embodiment of FIG. 6 may be implemented using an extruded or press-formed metal for rigidity due to its small size.

The position of the back bracket 330 fastened on the first fixing portion 325a of the neck portion 325 may be adjusted by forming the first fixing portion 325a to be long in the vertical direction. A plurality of fastening holes may be provided in the first fixing portion 325a to change the fastening position of the back bracket 330.

The back bracket 330 located on the rear surface of the display body 100' is a press-processed metal plate, and unevenness (beads) may be formed through press processing to secure rigidity for the back bracket 330.

The back bracket 330 includes first fastening holes 331 spaced apart from each other at a predetermined interval so that they may be coupled to VESA standard-based fastening holes located on the rear surface of the display body 100', and includes first fastening holes 331 fastened to the first fixing portion 325a of the neck portion 325.

A second region 330b with second fastening holes 332 formed therein may protrude in the front direction to be in close contact with the display body 100', and a first region 330a with the first fastening holes 331 formed therein may protrude in the back direction to provide a space where the first fixing portion 325a of the neck portion 325 is located.

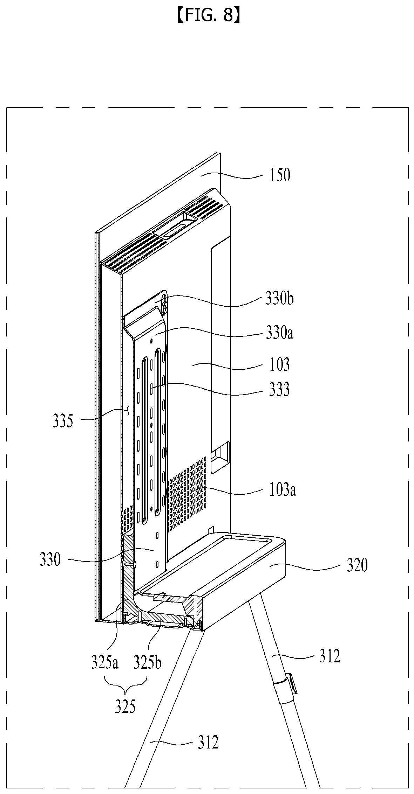

FIG. 8 is a cross-sectional view taken along line B-B of FIG. 4, and as illustrated in FIG. 8, the first region 330a may protrude in the back direction to form a space 335 spaced apart from the display body 100'. The back bracket 330 may overlap an opening 103a formed on the back cover, for heat dissipation. The back bracket 330 may be provided with a plurality of heat dissipation holes 333 so that heat emitted from the heat dissipation holes 333 is discharged without being blocked by the back bracket 330.

Further, since the first region 330a is spaced apart, heat may move through the separated space 335 and be discharged through the heat dissipation holes 333 of the back bracket 330. The heat dissipation holes 333 of the back bracket 330 may serve as perforation holes for inserting a fixing clip 337 for mounting the router 42 or the like on the rear surface, as illustrated in FIG. 4.

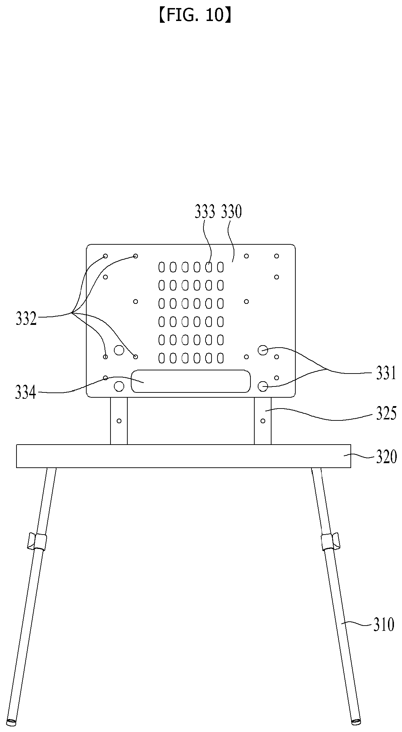

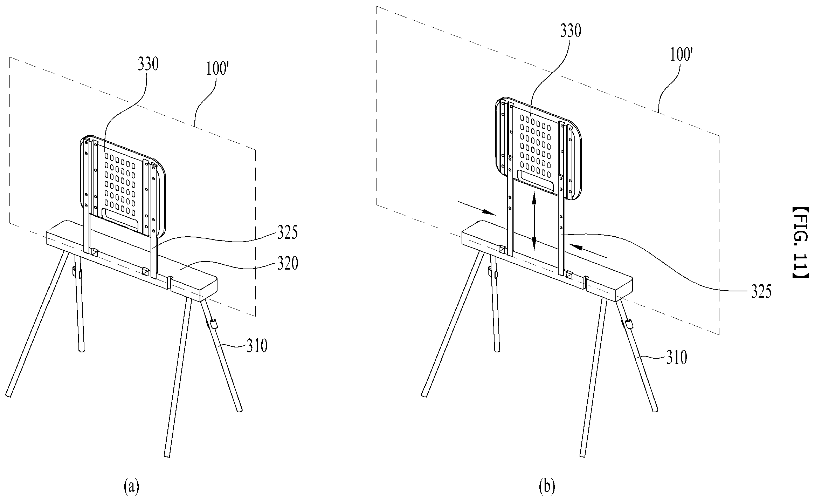

FIG. 9 is an exploded perspective view illustrating another example of the display stand 300 according to the disclosure, and FIG. 10 is a rear view illustrating the display stand 300 according to the disclosure. FIG. 11 is a diagram illustrating a conversion aspect of the display stand 300 according to the disclosure.

The neck portion 325 may have a bar shape in which the first fixing portion 325a and the second fixing portion 325b are bent in an L shape, and due to a small horizontal width, a pair of neck portions 325 may be provided, as illustrated in FIG. 9.

Grooves may be formed to correspond to positions at which the neck portions 325 are coupled, in the first region 330a of the back bracket 330. As illustrated in FIG 9, a plurality of first regions 330a may be provided spaced apart from each other in the horizontal direction, and a plurality of first fastening holes 331 may also be provided in the vertical direction.

As illustrated in FIG. 11, the fastening positions of the neck potions 325 and the back bracket 330 may be changed horizontally and vertically. Therefore, the display stand 300 of the disclosure may be applied to products with different sizes of display bodies 100' or different positions of VESA fastening holes.

In this embodiment, instead of arranging the back bracket 330 and the rear surface of the display body 100' to be spaced apart from each other, for heat dissipation, a large heat dissipation hole 334 may be formed in an area corresponding to the opening 103a of the display body 100' to discharge heat of the display body 100'.

Since the display device 100 of the disclosure may minimize the size of the display body 100', it may be easily converted to a wall-mounted type or a floor-mounted type.

Further, when the floor surface is not flat, the lengths of the stand legs 310 may be adjusted to make it level.

Further, as the leg brackets 323 include the guide portions 3232, they may fasten the stand legs 310 to accurate positions, and even if the fastening portions are loosened, the guide portions 3232 may support the display device 100.

Further, the set-top box 41 or the Wi-Fi repeater may be mounted on the rear surface of the display device 100, which may obviate the need for separate storage furniture.

The above detailed description should not be construed as being limitative in all terms, but should be considered as being illustrative.

## Claims

1. A display stand (300) comprising:
a stand body (320) extending in a horizontal direction and including a leg bracket (323);
three or more stand legs (310) including first spirals (315) located in an upper portion and fastened to second spirals (3231) of the leg bracket (323);
a back bracket (330) coupled to a rear surface of a display body (100'); and
an L-shaped neck portion (325) including a first fixing portion (325a) coupled to the back bracket (330) and a second fixing portion (325b) coupled to the stand body (320),
wherein the stand legs (310) include:
a front leg (311) extending obliquely from the stand body (320) in a front direction; and
a rear leg (312) extending obliquely from the stand body (320) in a back direction and shorter than the front leg (311),
wherein the leg bracket (323) includes:
guide portions extending downward from the second spirals (3231),
a first leg fastening portion (323a) to which the front leg (311) is coupled, and
a second leg fastening portion (323b) to which the rear leg (312) is coupled, and
wherein the first leg fastening portion (323a) is tilted at a greater angle with respect to a vertical direction than the second leg fastening portion (323b).

2. The display stand (300) according to claim 1, wherein the rear leg (312) includes a cable holder (319) for fixing a cable (188).

3. The display stand (300) according to claim 1, wherein the back bracket (330) includes a first fastening hole (331) fastened to the first fixing portion (325a) of the neck portion (325), and second fastening holes (332) coupled to the display body (100'), and
wherein the second fastening holes (332) are arranged at an interval based on a Video Electronics Standards Association (VESA) standard.

4. The display stand according to claim 3, wherein the back bracket (330) includes a plurality of first fastening holes (331) to change a fastening position of the back bracket (330) on the neck portion.

5. The display stand (300) according to claim 3, wherein in the back bracket (330), a first region (330a) where the first fastening hole (331) is located is spaced apart from the display body (100') by a predetermined distance, and a second region (330b) where the second fastening holes (332) are located is in close contact with the rear surface of the display body (100'), and
wherein the second fixing portion (325b) of the neck portion (325) is located in a separation space between the first region (330a) of the back bracket (330) and the display body (100').

6. The display stand (300) according to claim 1, wherein the back bracket (330) includes a plurality of heat dissipation holes (333).

7. The display stand (300) according to claim 6, further comprising a fixing clip (337) inserted into the plurality of heat dissipation holes (333).

8. The display stand (300) according to claim 1, further comprising a storage portion on the stand body (320).

9. A display device (100) comprising:
the display stand (300) of any of claim 1 to 8, and
the display body (100') including a display module outputting an image.

## Patentansprüche

1. Anzeigeständer (300), umfassend:
einen Ständerkörper (320), der sich in horizontaler Richtung erstreckt und eine Beinhalterung (323) umfasst;
drei oder mehr Standbeine (310) mit ersten Spiralen (315), die sich in einem oberen Abschnitt befinden und an zweiten Spiralen (3231) der Beinhalterung (323) befestigt sind;
eine hintere Halterung (330), die mit einer Rückseite eines Anzeigekörpers (100') verbunden ist; und
einen L-förmigen Halsabschnitt (325) mit einem ersten Befestigungsabschnitt (325a), der mit der hinteren Halterung (330) verbunden ist, und mit einem zweiten Befestigungsabschnitt (325b), der mit dem Ständerkörper (320) verbunden ist,
wobei die Standbeine (310) umfassen:
ein vorderes Bein (311), das sich schräg vom Ständerkörper (320) in einer vorderen Richtung erstreckt; und
ein hinteres Bein (312), das sich schräg vom Ständerkörper (320) in einer hinteren Richtung erstreckt und kürzer als das vordere Bein (311) ist,
wobei die Beinhalterung (323) umfasst:
Führungsabschnitte, die sich von den zweiten Spiralen (3231) nach unten erstrecken,
einen ersten Befestigungsabschnitt (323a), mit dem das vordere Bein (311) verbunden ist, und
einen zweiten Befestigungsabschnitt (323b), mit dem das hintere Bein (312) verbunden ist, und
wobei der erste Beinbefestigungsabschnitt (323a) in Bezug auf eine vertikale Richtung in einem größeren Winkel geneigt ist als der zweite Beinbefestigungsabschnitt (323b).

2. Anzeigeständer (300) gemäß Anspruch 1, wobei das hintere Bein (312) einen Kabelhalter (319) zum Befestigen eines Kabels (188) umfasst.

3. Anzeigeständer (300) gemäß Anspruch 1, wobei die hintere Halterung (330) ein erstes Befestigungsloch (331), das an dem ersten Befestigungsabschnitt (325a) des Halsabschnitts (325) befestigt ist, und zweite Befestigungslöcher (332), die mit dem Displaykörper (100') verbunden sind, umfasst, und
wobei die zweiten Befestigungslöcher (332) in einem Abstand angeordnet sind, der auf einem Standard der Video Electronics Standards Association (VESA) basiert.

4. Anzeigeständer gemäß Anspruch 3, wobei die hintere Halterung (330) mehrere erste Befestigungslöcher (331) umfasst, um eine Befestigungsposition der hinteren Halterung (330) am Halsabschnitt zu ändern.

5. Anzeigeständer (300) gemäß Anspruch 3, wobei in der hinteren Halterung (330) ein erster Bereich (330a), in dem sich die ersten Befestigungslöcher (331) befinden, in einem vorbestimmten Abstand vom Anzeigekörper (100') angeordnet ist und ein zweiter Bereich (330b), in dem sich die zweiten Befestigungslöcher (332) befinden, in engem Kontakt mit der Rückseite des Anzeigekörpers (100') stehen, und
wobei sich der zweite Befestigungsabschnitt (325b) des Halsabschnitts (325) in einem Trennraum zwischen dem ersten Bereich (330a) der hinteren Halterung (330) und dem Anzeigekörper (100') befindet.

6. Anzeigeständer (300) gemäß Anspruch 1, wobei die hintere Halterung (330) eine Mehrzahl von Wärmeableitungslöchern (333) umfasst.

7. Anzeigeständer (300) gemäß Anspruch 6, der ferner eine Befestigungsklammer (337) umfasst, die in die Mehrzahl von Wärmeableitungslöcher (333) eingesetzt ist.

8. Anzeigeständer (300) gemäß Anspruch 1, der ferner einen Aufbewahrungsbereich am Ständerkörper (320) umfasst.

9. Anzeigeeinrichtung (100), umfassend:
den Anzeigeständer (300) gemäß einem der Ansprüche 1 bis 8 und
den Anzeigekörper (100'), der ein ein Bild ausgebendes Anzeigemodul umfasst.

## Revendications

1. Support d'afficheur (300) comprenant:
un corps de support (320) s'étendant dans une direction horizontale et comprenant un support de pied (323);
au moins trois pieds de support (310) comprenant des premières spirales (315) situées dans une partie supérieure et fixées à des secondes spirales (3231) du support de pied (323);
une console arrière (330) accouplée à une surface arrière d'un corps d'afficheur (100'); et
une partie col en forme de L (325) comprenant une première partie de fixation (325a) accouplée à la console arrière (330) et une deuxième partie de fixation (325b) accouplée au corps du support (320),
dans lequel les pieds du support (310) comprennent:
un pied avant (311) s'étendant obliquement depuis le corps de support (320) vers l'avant; et
un pied arrière (312) s'étendant obliquement depuis le corps du support (320) vers l'arrière et plus court que le pied avant (311),
dans lequel le support de pied (323) comprend:
des parties de guidage s'étendant vers le bas à partir des deuxièmes spirales (3231),
une première partie de fixation de pied (323a) à laquelle est accouplé le pied avant (311), et
une deuxième partie de fixation de pied (323b) à laquelle est accouplé le pied arrière (312), et
dans lequel la première partie de fixation de pied (323a) est inclinée selon un angle supérieur à la direction verticale que la deuxième partie de fixation de pied (323b).

2. Support d'afficheur (300) selon la revendication 1, dans lequel le pied arrière (312) comprend un support de câble (319) pour fixer un câble (188).

3. Support d'afficheur (300) selon la revendication 1, dans lequel la console arrière (330) comprend un premier trou de fixation (331) fixé à la première partie de fixation (325a) de la partie col (325), et des seconds trous de fixation (332) couplés au corps d'afficheur (100').
dans lequel les seconds trous de fixation (332) sont disposés à un intervalle conformément à une norme VESA (Video Electronics Standards Association).

4. Support d'afficheur (300) selon la revendication 3, dans lequel la console arrière (330) comprend une pluralité de premiers trous de fixation (331) servant à modifier la position de fixation de la console arrière (330) sur la partie col.

5. Support d'afficheur (300) selon la revendication 3, dans lequel, dans la console arrière (330), une première zone (330a) où se trouve le premier trou de fixation (331) est espacée du corps d'afficheur (100') d'une distance prédéterminée, et une deuxième région (330b) où se trouvent les deuxièmes trous de fixation (332) est en contact étroit avec la surface arrière du corps d'afficheur (100'), et
dans lequel la deuxième partie de fixation (325b) de la partie col (325) est située dans un espace de séparation entre la première région (330a) de la console arrière (330) et le corps d'afficheur (100').

6. Support d'afficheur (300) selon la revendication 1, dans lequel la console arrière (330) comprend une pluralité de trous de dissipation thermique (333).

7. Support d'afficheur (300) selon la revendication 6, comprenant en outre un clip de fixation (337) inséré dans la pluralité de trous de dissipation thermique (333).

8. Support d'afficheur (300) selon la revendication 1, comprenant en outre une partie de rangement sur le corps de support (320).

9. Dispositif d'affichage (100), comprenant:
le support d'afficheur (300) selon l'une quelconque des revendications 1 à 8, et
le corps d'afficheur (100') comprenant un module d'affichage délivrant une image.
